# EUROPÄISCHE PATENTANMELDUNG

(11) **EP 4 589 779 A1**
(43) Veröffentlichungstag der Anmeldung: **23.07.2025**
(21) Anmeldenummer: 24152356.2
(22) Anmeldetag: 17.01.2024
(51) Int. Cl.: H01R 4/48, H01R 4/70, H01R 12/51

(54) **FEDERKRAFTKLEMMENSCHUTZ**

(71) Anmelder: C. & E. Fein GmbH, 73529 Schwäbisch Gmünd-Bargau (DE)
(72) Erfinder: Dürnegger, Wolfgang, 73614 Schorndorf (DE); Scherrenbacher, Stefan, 73550 Waldstetten (DE); Wittlich, Robert, 73568 Durlangen (DE)
(74) Vertreter: Wallinger Ricker Schlotter Tostmann

(57) **Zusammenfassung**

Die Erfindung betrifft ein Abdeckelement (10) zum Abdecken einer mit einer Leiterplatte (400) verbindbaren Federkraftklemmeinrichtung (50), aufweisend einen Verbindungsabschnitt (24; 25) zur Verbindung des Abdeckelements mit einem Verbindungsabschnitt (64; 65) der Federkraftklemmeinrichtung (50) und einen Abdeckabschnitt (14) zum Abdecken einer Leitungsaufnahme (57) der Federkraftklemmeinrichtung (50), wobei der Abdeckabschnitt (14) einen Öffnungskanal (30) zur formschlüssigen und/oder kraftschlüssigen Aufnahme einer Anschlusslitze (100) aufweist, durch den ein Leiter (102) der Anschlusslitze führbar und in die Leitungsaufnahme (57) der Federkraftklemmeinrichtung (50) einführbar ist. Die Erfindung betrifft auch ein Klemmsystem und ein Verfahren zur Herstellung des Abdeckelements.

## Beschreibung

Die Erfindung bezieht sich auf ein Abdeckelement einer Federkraftklemmeinrichtung, die mit einer Leiterplatte verbunden bzw. verbindbar ist, ein Verfahren zur Herstellung des Abdeckelements, sowie ein mit diesem Abdeckelement ausgestattetes Klemmsystem und ein Elektrowerkzeug.

Elektrowerkzeuge, insbesondere handgeführte Elektrowerkzeuge, werden in vielen Branchen unter verschiedenartigsten Einsatzbedingungen eingesetzt. Neben einer hohen Leistungsdichte und einer ergonomischen Gerätegestalt zählen Robustheit und Zuverlässigkeit zu den wichtigsten Geräteanforderungen.

Speziell im Einsatz bei metallischen Werkstoffen treten vielfältige Zusatzanforderungen auf, da die durch die Metallanwendung emittierten Stäube abrasive, elektrisch leitfähige, heiße und gesundheitsschädliche Bestandteile aufweisen können.

Handgeführte Elektrowerkzeuge werden oft in diesem Milieu betrieben, insbesondere sind diesen Emissionen die im Inneren des handgeführten Elektrowerkzeugs angeordneten elektrischen Komponenten exponiert ausgesetzt, da zu deren Kühlung Umgebungsluft herangezogen wird.

So treten infolge der mit Metallpartikeln kontaminierten Umgebungsluft, die zur Kühlung des handgeführten Elektrowerkzeugs durch das Maschinengehäuse gezogen wird, Anlagerungen von Metallpartikeln auf, die durch fortschreitende Agglomeration elektrisch leitfähige Pfade aufbauen können. Diese können in Folge von Erwärmung und Kurzschlüssen zum Abbrand der Werkzeuge führen. Im schlimmsten Falle kann dadurch der Bediener einer Gefahr ausgesetzt sein.

In der Regel werden handgeführte Elektrowerkzeuge, insbesondere Winkelschleifer, auf Baustellen so lange verwendet wie diese funktionsfähig sind. Empfohlene Wartungs- bzw. Reinigungsintervalle werden nicht oder unsachgemäß durchgeführt, wodurch die oben beschriebenen Gefahren nicht verhindert werden können.

Federkraftklemmen werden eingesetzt, um Elektronikbaugruppen mit flexiblen Leitern lösbar zu verbinden. Insbesondere dienen sie oftmals als lösbare Verbindung zwischen der Stromversorgung (Netzanschlussleitung, Akku) und dem Elektronikmodul. Topografiebedingt ist es nicht immer möglich, die Netzanschlussklemmen räumlich weit voneinander zu platzieren und dadurch die unterschiedlichen Netzpotentiale hinreichend weit voneinander zu trennen. Die oben beschriebenen Emissionen können zu metallstaubinduzierten elektrisch leitfähigen Pfaden, Kriechströmen und Kurzschlüssen führen und dadurch die sukzessive Zerstörung des Elektronikmoduls bewirken.

Es ist allgemein bekannt, Federkraftklemmen mit den bereits mit diesen verbundenen Leitern mittels eines stoffschlüssigen Überzugs zu versehen und dadurch die Kontaktstellen (Federkraftklemme, Leiter) zu schützen. Dieser Überzug bietet einen ausreichenden Schutz, schränkt allerdings die eigentliche Funktion einer Federkraftklemme ein. Eine Federkraftklemme dient in der Elektrotechnik zum lösbaren Anschluss oder der Verbindung von Drähten, Adern und Leitungen und findet Anwendung, wenn eine sichere, aber lösbare Kontaktstelle beispielsweise zwischen einer Leiterplatte und einem Leiter benötigt wird. Wird eine Kontaktstelle mit einem stoffschlüssigen Überzug versehen, muss dieser im Falle einer Dekontaktierung entfernt werden. Dies ist sehr häufig rückstandslos nicht möglich. Beim Widereinsatz der Elektronikeinheit mit der Federkraftklemme ist es erforderlich, den stoffschlüssigen Überzug zu erneuern.

Marktgängig sind keine Federkraftklemmen verfügbar, die die notwendige Kompaktheit für derartige Elektronikeinheiten aufweisen bzw. staubdicht und vergusssicher auf Leiterplatten assembliert werden können. Der Kontakt- und Betätigungsbereich von marktgängigen Federkraftklemmen ist vielmehr offen gestaltet und bietet dadurch keinerlei Schutz- oder Barrierewirkung gegenüber metallischen Stäuben.

Die Erfindung hat zur Aufgabe, eine Federkraftklemmeinrichtung vor Umwelteinflüssen zu schützen und abzudichten, ohne deren Funktionalität, das sichere, aber lösbare Kontaktieren von Leitern, wesentlich einzuschränken.

Die Erfindung löst diese Aufgabe durch das Abdeckelement gemäß Patentanspruch 1 und ein Verfahren zu dessen Herstellung gemäß Patentanspruch 15. Bevorzugte Ausgestaltungen der Erfindung sind Gegenstände der abhängigen Ansprüche und ergeben sich zudem aus der weiteren Beschreibung der Erfindung.

Durch die erfindungsgemäße Gestaltung des Abdeckelements ist für ein System, welches das Abdeckelement, die Federkraftklemmeinrichtung und die Anschlusslitze beinhaltet, eine Anschlusskonfiguration einfach herstellbar, in der die Leitung der Anschlusslitze in der Leitungsaufnahme der Federkraftklemmeinrichtung eingeklemmt ist, die Anschlusslitze formschlüssig in dem Öffnungskanal des Abdeckelements aufgenommen ist und das Abdeckelement mit der Federkraftklemmeinrichtung verbunden ist und diese abdeckt. Durch den Abdeckabschnitt und die formschlüssige Aufnahme der Anschlusslitze im Öffnungskanal wird verhindert, dass Metallstaub in die Leitungsaufnahme gerät.

Der Öffnungskanal bildet einen Durchgang durch den Abdeckabschnitt. Der Öffnungskanal ist vorzugsweise hohlzylinderförmig und zur form- und/oder kraftschlüssigen Aufnahme einer zylinderförmigen Anschlusslitze ausgebildet.

Vorzugsweise erstreckt sich der Öffnungskanal vom Abdeckabschnitt weg, insbesondere ist der Öffnungskanal senkrecht zu einem planaren Abdeckabschnitt angeordnet.

Der Öffnungskanal erfüllt einerseits die Aufgabe, durch die formschlüssige und/oder kraftschlüssige Litzenaufnahme eine Abdichtwirkung zu erzielen. Andererseits wird die Anschlusslitze durch den Öffnungskanal in Richtung der Leitungsaufnahme ausgerichtet, so dass ein Einführen der Leitung in die Leitungsaufnahme unterstützt wird. Zudem führen die Verbindung der Federkraftklemmeinrichtung mit dem Abdeckelement und die formschlüssige Aufnahme der Anschlusslitze in den Öffnungskanal dazu, dass eventuelle, auf die Anschlusslitze wirkende Vibrationen gedämpft werden und die Klemmverbindung der Leitung mit der Federkraftklemmeinrichtung entlastet wird. Dadurch wird die Zuverlässigkeit der elektrischen Kontaktierung verbessert.

Vorzugsweise weist der Öffnungskanal mindestens eine Abdichtungseinrichtung auf, insbesondere um das Eindringen von Partikeln durch den Öffnungskanal zu verhindern.

Die Abdichtungseinrichtung beinhaltet vorzugsweise einen im zylinderförmigen Öffnungskanal ausgebildeten, umlaufenden, insbesondere ringförmigen, Vorsprungsabschnitt. Der Vorsprungsabschnitt verläuft insbesondere konzentrisch zum kreisförmigen Kanalquerschnitt an der Innenwand des Öffnungskanals. Dieser Vorsprungsabschnitt ist insbesondere dazu ausgebildet, zwischen dem Öffnungskanal und der Anschlusslitze eine kraftschlüssige Verbindung zu erzeugen, indem der Vorsprungsabschnitt in ein nachgiebiges Material eines Isolationsmantels der Anschlusslitze gepresst wird, wenn diese durch den Vorsprungsabschnitt geführt und im Öffnungskanal aufgenommen ist, und/oder indem der Vorsprungsabschnitt selbst nachgiebig bzw. elastisch ist. Übt der eingedrückte Isolationsmantel oder der Vorsprungsabschnitt eine Rückstellkraft aus, so wird die Anschlusslitze kraftschlüssig im Öffnungskanal aufgenommen.

Die Abdichtungseinrichtung beinhaltet vorzugsweise ein ringförmiges, im zylinderförmigen Öffnungskanal angeordnetes Dichtungselement.. Das Dichtungselement kann integraler Bestandteil der Abdichtungseinrichtung bzw. des Öffnungskanals sein oder alternativ beispielsweise ein O-Ring. Dieses Dichtungselement ist insbesondere dazu ausgebildet, zwischen dem Öffnungskanal und der Anschlusslitze eine kraftschlüssige Verbindung zu erzeugen, indem das Dichtungselement in ein nachgiebiges Material eines Isolationsmantels der Anschlusslitze gepresst wird, wenn diese durch das Dichtungselement geführt und im Öffnungskanal aufgenommen ist, und/oder indem das Dichtungselement selbst nachgiebig bzw. elastisch ist.

Vorzugsweise erstreckt sich der Öffnungskanal vom Abdeckabschnitt weg. Vorzugsweise erstreckt sich der Öffnungskanal entlang einer Längsachse. Vorzugsweise weist der Öffnungskanal eine erste Öffnung auf, die in den Innenraum einer Öffnung des Abdeckelements mündet. Vorzugsweise weist der Öffnungskanal einen Kanalabschnitt auf, der in Richtung der ersten Öffnung einen abnehmenden Öffnungsquerschnitt hat und der insbesondere in der ersten Öffnung mündet. Der Öffnungsquerschnitt in der ersten Öffnung und/oder entlang des gesamten Öffnungskanals hat einen Durchmesser von 1 mm bis 4 mm und ist geeignet, dass Anschlusslitzen mit unterschiedlichen Außendurchmessern einführbar und durchführbar sind. Diese Außendurchmesser liegen zwischen 1 mm bis 4 mm, vorzugsweise 2 mm bis 3,7mm und besonders vorzugsweise zwischen 2,5 mm bis 3,5 mm(einschließlich dieser Werte). Dies ermöglicht einen staubdichten Verschluss von eingeschobenen Anschlusslitzen mit unterschiedlichem Außendurchmesser.

Alternativ kann der Öffnungsquerschnitt des Öffnungskanals ausgehend von der ersten Öffnung in Richtung der zweiten Öffnung zunehmend ausgebildet sein. Dabei ist die zweite Öffnung, die Stelle, an der ein Leiter in den Öffnungskanal eingeführt wird.

Der Öffnungskanal ist insbesondere ein integraler Bestandteil des Abdeckelements. Er kann aber auch als ein auswechselbares Teil gebildet sein. Es können Wechseleinsätze vorgesehen sein, die in eine entsprechende Aufnahme des Abdeckelements aufnehmbar sind und die unterschiedliche Öffnungskanäle mit unterschiedlichen Öffnungsdurchmessern haben, insbesondere um das Abdeckelement für Anschlusslitzen mit stärker verschiedenen Durchmessern nutzbar zu machen. Der Öffnungskanal oder der Wechseleinsatz kann ein nachgiebiges Material aufweisen oder aus diesem gefertigt sein.

Der Abdeckabschnitt ist vorzugsweise insgesamt oder abschnittsweise planar, er kann aber auch insgesamt oder abschnittsweise gewölbt sein. Der Abdeckabschnitt ist insbesondere ein integraler Bestandteil des Abdeckelements.

Der Verbindungsabschnitt des Abdeckelements kann insbesondere zur Herstellung einer form- und/oder kraftschlüssigen Verbindung mit dem Verbindungsabschnitt der Federkraftklemmeinrichtung eingerichtet sein. Der Verbindungsabschnitt des Abdeckelements ist vorzugsweise als Vorsprung des Abdeckelements, insbesondere als Zapfen oder Rastnocke, oder als Aussparung oder Öffnung des Abdeckelements ausgebildet, die jeweils zum Eingriff oder zur Aufnahme eines komplementären Verbindungsabschnitts an der Federkraftklemmeinrichtung ausgebildet sein können. Ein in den Innenraum des Abdeckelements weisender Teilabschnitt des Abdeckelements, insbesondere des Öffnungskanals, ist vorzugsweise als Verbindungsabschnitt des Abdeckelements ausgebildet, das in Montageposition form- und oder kraftschlüssig in die Leiteraufnahme der Federkraftklemmeinrichtung eingreift.

Das Abdeckelement weist vorzugsweise ein, zwei drei oder mehr Verbindungsabschnitte auf. Diese sind vorzugsweise jeweils zum Eingriff oder zur Aufnahme eines komplementären Verbindungsabschnitts an der Federkraftklemmeinrichtung ausgebildet.

Das Abdeckelement ist vorzugsweise in Integralbauweise hergestellt, insbesondere durch ein Spritzgussverfahren hergestellt oder durch ein additives Herstellungsverfahren.

Das Abdeckelement ist vorzugsweise aus einem elektrisch nichtleitenden Material gefertigt oder weist dieses auf. Das Material des Abdeckelements kann insbesondere ein Kunststoff sein, insbesondere gewählt aus Duroplasten, Thermoplasten oder Elastomeren, insbesondere Silikonen, insbesondere PTFE, bzw. eine Kombination aus den genannten Materialien.

Eine Federkraftklemme für elektrische Leiter wird in der Elektrotechnik verwendet, um elektrische Leiter wie Drähte oder Kabel sicher und zuverlässig reversibel zu verbinden. Diese Klemmen nutzen die Kraft einer Feder, um den elektrischen Leiter festzuhalten und elektrisch zu kontaktieren, ohne dass Löten oder Schrauben erforderlich sind.

Federkraftklemmen beinhalten insbesondere ein Gehäuse, in dem sich eine oder mehrere metallene Klemmbacken befinden. Wenn der elektrische Leiter eingeführt wird, drückt eine Feder der Federkraftklemme die Klemmbacken zusammen, was eine elektrische und mechanische Verbindung herstellt. Diese Art von Klemmen wird oft in Schalttafeln, elektrischen Schaltungen oder Anschlusskästen verwendet, da sie eine schnelle und sichere Verbindung ermöglichen und auch eine einfache Wartung oder Entfernung des Leiters ermöglichen.

Die Federkraftklemmeinrichtung weist einen Verbindungsabschnitt zur Verbindung des Abdeckelements mit der Federkraftklemmeinrichtung auf und eine Leitungsaufnahme. Die Federkraftklemmeinrichtung kann insbesondere einen, zwei, drei oder mehrere solcher Verbindungsabschnitte aufweisen.

Die Klemmfunktionalität zum Festklemmen eines Leiters der Anschlusslitze wird insbesondere durch eine Klemmeinrichtung der Federkraftklemmeinrichtung ermöglicht. Optional weist die Federkraftklemmeinrichtung einen Basiskörper auf, an dem der Verbindungsabschnitt, die Leitungsaufnahme und insbesondere die Klemmeinrichtung angeordnet sind. Der Basiskörper kann ein Gehäuse der Federkraftklemmeinrichtung sein oder dieses aufweisen.

Der Basiskörper ist vorzugsweise aus einem elektrisch nichtleitenden Material gefertigt oder weist dieses auf. Das Material des Basiskörpers kann insbesondere ein Kunststoff sein, insbesondere gewählt aus Duroplasten, Thermoplasten oder Elastomeren, insbesondere Silikonen, insbesondere PTFE, bzw. eine Kombination aus den genannten Materialien.

Die Klemmeinrichtung beinhaltet insbesondere eine oder mehrere metallene Klemmbacken. Wenn der elektrische Leiter eingeführt wird, drückt eine Feder der Federkraftklemme die Klemmbacken zusammen, was eine elektrische und mechanische Verbindung herstellt. Die Klemmfunktionalität kann aber auch mittels anderer Klemmteile realisiert sein.

Die Leitungsaufnahme beinhaltet einen nach außen geöffneten Bereich der Federkraftklemmeinrichtung, durch den ein Leiter der Anschlusslitze in die Federkraftklemmeinrichtung einführbar ist und insbesondere bis in die Klemmeinrichtung führbar ist. Wenn das Abdeckelement in einer Montageposition mit der Federkraftklemmeinrichtung verbunden ist, ist der Öffnungskanal des Abdeckelements zum geöffneten Bereich der Federkraftklemmeinrichtung so ausgerichtet, dass eine im Öffnungskanal eingeführte Anschlusslitze durch den geöffneten Bereich führt. Insbesondere ist in dieser Montageposition ein Leiter der Anschlusslitze in der Klemmeinrichtung eingeführt, die entsprechend der Richtung des Öffnungskanals und des geöffneten Bereichs ausgerichtet ist. Die Ausrichtung des Öffnungskanals, des geöffneten Bereichs und der Klemmeinrichtung ist insbesondere so, dass die genannten Komponenten entlang einer zentralen Achse des Öffnungskanals angeordnet sind.

Der geöffnete Bereich kann eine Öffnung in einem optionalen Gehäuse der Federkraftklemmeinrichtung sein oder durch eine fehlende Bedeckung der Klemmeinrichtung realisiert sein. Der Öffnungsquerschnitt des geöffneten Bereichs ist insbesondere größer als der Öffnungsquerschnitts des Öffnungskanals des Abdeckelements.

Die Federkraftklemmeinrichtung kann einen Eingriffsbereich aufweisen, insbesondere eine Öffnung im optionalen Gehäuse der Federkraftklemmeinrichtung, durch den ein Werkzeug einführbar ist, mit dem die Klemmverbindung des in der Klemmeinrichtung eingeklemmten Leiters lösbar ist. Dies kann erfolgen, indem ein langgestrecktes Werkzeug eingeführt wird, mittels dem eine Feder der Klemmeinrichtung durch den Anwender gespannt wird, wodurch sich zum Beispiel die Klemmbacken voneinander lösen. Insbesondere wenn kein Gehäuse vorgesehen ist, kann der Eingriffsbereich auch durch eine fehlende Bedeckung der Klemmeinrichtung realisiert sein.

Die Federkraftklemmeinrichtung kann auch eine Betätigungseinrichtung aufweisen, mittels der die Klemmverbindung des in der Klemmeinrichtung eingeklemmten Leiters werkzeuglos lösbar ist. Die Betätigungseinrichtung kann einen beweglichen Stift beinhalten, der insbesondere im Gehäuse oder im Basiskörper beweglich gelagert sein kann, durch dessen Auslenkung eine Feder der Klemmeinrichtung durch den Anwender spannbar ist, wodurch sich zum Beispiel die Klemmbacken voneinander lösen.

Durch eine -insbesondere zerstörungsfrei und reversibel- ausgebildete Verbindung des Verbindungsabschnitts mit dem komplementären Verbindungsabschnitt der Federkraftklemmeinrichtung ist zum Lösen der Anschlusslitze das Abdeckelement insbesondere abnehmbar gestaltet. Diese Verbindung kann insbesondere formschlüssig sein und kann insbesondere eine Rastverbindung sein. Alternativ oder zusätzlich kann das Abdeckelement ein Betätigungselement aufweisen, das mit der Federkraftklemmeinrichtung derart koppelbar ist, dass durch eine Betätigung des Betätigungselements die Klemmverbindung lösbar ist und die Anschlusslitze dem Öffnungskanal entnommen werden kann. Die Betätigungseinrichtung kann einen beweglichen Stift beinhalten, der insbesondere im Abdeckelement beweglich gelagert sein kann, durch dessen Auslenkung eine Feder der Klemmeinrichtung durch den Anwender spannbar ist, wodurch sich zum Beispiel die Klemmbacken voneinander lösen.

Vorzugsweise ist ein Becherelement vorgesehen, in dem die Federkraftklemmeinrichtung angeordnet wird. Das Becherelement kann auch Bestandteil der Federkraftklemmeinrichtung sein. Ein solches Becherelement dient der räumlichen Abtrennung der Federkraftklemmeinrichtung, insbesondere der darin angeordneten elektrischen Kontakte, von der Umgebung. Insbesondere dient ein Becherelement als Vergussbecher, der es ermöglicht, bei einer auf einer Leiterplatte angebrachten Federkraftklemmeinrichtung eine Vergussmasse aufzubringen, welche die elektrischen Kontakte auf der Leiterplatte abdeckt. Das Becherelement verhindert das Eindringen von Vergussmasse in die Federkraftklemmeinrichtung und verhindert so, dass die reversibel festgeklemmten Leiter durch die Vergussmasse verklebt werden.

Das Becherelement ist bei Montage auf einer Leiterplatte insbesondere so angeordnet, dass die Öffnung des Becherelements, durch welche die Federkraftklemmeinrichtung in das Becherelement eingesetzt wird, von der Leiterplatte wegweist, also "nach oben" weist. Das Becherelement kann ein, zwei oder mehr Öffnungen oder Aussparungen aufweisen, durch welche Kontaktpins oder Leiter der Federkraftklemmeinrichtung geführt sein können, insbesondere um mit der Leiterplatte verbunden zu werden. Diese Öffnungen sind vorzugsweise in einem Bodenabschnitt des Becherelements angebracht. Ein Nachteil solcher Öffnungen, in denen Kontaktpins nach außen geführt sind, liegt darin, dass bei Verwendung von Vergussmasse diese durch die Öffnungen ins Becherinnere eindringen und somit an die festgeklemmten Leiter gelangen kann.

Vorzugsweise weist deshalb das Becherelement ein Barriereeinrichtung auf, die im Inneren des Becherelements, insbesondere auf dessen Bodenplatte angebracht ist. Die Barriereeinrichtung verhindert das Eindringen von Staub oder Vergussmasse in den bodenseitigen Bereich der Kontaktpins. Die Barriereeinrichtung kann insbesondere eine Barriereschicht beinhalten, welche auf der Bodenplatte des Becherelements angeordnet und/oder aufgebracht sein kann. Diese Barriereschicht kann als Abdichtung zwischen Federkraftklemmeinrichtung und Becherelement dienen.

Die Barriereeinrichtung weist vorzugsweise, alternativ oder zusätzlich zu einer Barriereschicht, eine stoffschlüssige Paste auf, welche die Barriereschicht darstellt bzw. die Barrierewirkung verstärkt.

Die Barriereeinrichtung kann alternativ oder zusätzlich auch Barriereelemente aufweisen, die, angeordnet zwischen Federkraftklemmeinrichtung und Becherelement, eine formschlüssige Verbindung bzw. Barriere zwischen Federkraftklemmeinrichtung und Becherelement herstellen, wenn die beiden Komponenten verbunden werden. Die Barriereelemente können dazu ausgebildet sein, um zwischen Federkraftklemmeinrichtung und Becherelement eine formschlüssige Verbindung herzustellen und können insbesondere ineinander eingreifende Strukturen beinhalten, insbesondere Erhebungen und Vertiefungen. Die Barriereelemente können beispielsweise Erhebungen in Form von Vorsprüngen am Boden des Vergussbechers mit Ausnehmungen in Form von Nuten an der Federkraftklemme bilden, um eine formschlüssige Verbindung zu bilden.

Das Becherelement kann einen Verbindungsabschnitt zur Verbindung des Becherelements mit dem Abdeckelement aufweisen. In diesem Fall ist es nicht notwendig, dass die Federkraftklemmeinrichtung diesen Verbindungsabschnitt aufweist.

Die Barriereschicht besteht vorzugsweise aus einem elektrisch nichtleitenden Material oder weist dieses auf. Bei dem Material kann es sich insbesondere um Elastomere handeln, insbesondere elastisch und oder plastisch vorgespannte Elastomere, PU, Silikone, sowie deren Schäume (geschlossenporig) und / oder gelartige Ausprägungen. Auch bevorzugt für das Material sind fest aushärtende Vergussmassen oder Klebstoffe auf 1- oder 2K Basis, Lacke und Pasten, pastöse elektrisch nichtleitende Substrate bzw. eine Kombination aus den genannten.

Die Erfindung betrifft insbesondere ein Klemmsystem, das eine Federkraftklemmeinrichtung und ein mit dieser verbindbares erfindungsgemäßes Abdeckelement aufweist. Durch eine reversible Verbindung dieser beiden Komponenten des Klemmsystems ergibt sich der Vorteil, dass eine Eingriffsöffnung der Federkraftklemmeinrichtung in Montageposition zum Zweck der Staubabdichtung zwar vom Abdeckelement abgedeckt ist und somit für das Lösen der Klemmverbindung nicht zugänglich ist, dass aber durch Abnehmen des Abdeckelements der Zugriff auf die Eingriffsöffnung und das Lösen der Klemme wieder ermöglicht wird. Vorzugsweise verkapselt das Abdeckelement die Federkraftklemmeinrichtung in der Montageposition vollständig und weist den Öffnungskanal in der Montageposition als alleinige Öffnung auf.

Vorzugsweise weist das Klemmsystem eine ein- oder mehradrige Anschlusslitze auf, die einen Isoliermantel aufweist, welcher form- und/oder kraftschlüssig im Öffnungskanal des Abdeckelements angeordnet ist. Das Abdeckelement ist dann vorzugsweise vollständig gegen den Eintritt von Partikeln in den Innenraum des Abdeckelements abgedichtet. Vorzugsweise verkapselt das Abdeckelement die Federkraftklemmeinrichtung in der Montageposition vollständig, insbesondere indem der Öffnungskanal durch die Anschlusslitze verschlossen ist.

Das Klemmsystem beinhaltet vorzugsweise auch ein Becherelement, wie zuvor beschrieben. In diesem kann die Federkraftklemmeinrichtung angeordnet sein oder ausgebildet sein. Insbesondere können das Becherelement und die Federkraftklemmeinrichtung auch fest und/oder integral miteinander verbunden sein.

Bevorzugt ist aber auch ein Klemmsystem, dessen Federkraftklemmeinrichtung fest mit dem erfindungsgemäßen Abdeckelement verbunden ist, bei dem es also nicht vorgesehen ist, zum Lösen der Kontaktierung bzw. zum Entnehmen der angeschlossenen Anschlusslitze das Abdeckelement zuvor abzunehmen. Ein solches Klemmsystem bietet unmittelbar die Funktionalität einer Federkraftklemme, bildet somit eine Federkraftklemme mit dem Vorteil der Staubdichtigkeit. Das Klemmsystem kann dann insbesondere zum Lösen der Klemmverbindung ein Betätigungselement aufweisen, das beweglich im Abdeckelement angeordnet ist, wie bereits beschrieben. Durch diese werkzeuglose Lösbarkeit der Klemmverbindung kann eine offene Eingriffsöffnung im Abdeckelement und damit ein potenzielles Einfallstor für den Staubeintritt vermieden werden. In einer bevorzugten Ausführungsform bildet das Klemmsystem eine Federkraftklemme, welche gegenüber marktgängigen Federkraftklemmen den Vorteil einer staubdichten Verbindung der Klemmeinrichtung und des Leiters und somit Schutz von der Umgebung bietet.

Die Erfindung betrifft auch eine Leiterplatte, die insbesondere mit mindestens einem elektronischem Bauteil bestückt ist, und die ein erfindungsgemäßes Abdeckelement oder ein erfindungsgemäßes Klemmsystem aufweist.

Die Erfindung betrifft auch ein Verfahren zur Herstellung des erfindungsgemäßen Abdeckelements, aufweisend die Schritte:
- Bereitstellen eines Materials, insbesondere eines nicht elektrisch leitfähigen Kunststoffs;
- Fertigen des Abdeckelements als integrales Bauteil, insbesondere mittels eines additiven Herstellungsverfahrens oder mittels eines Spritzgussverfahrens.

Eine Anschlusslitze kann einadrig oder mehradrig sein.

Die Erfindung betrifft auch ein handgehaltenes Elektrowerkzeug, insbesondere Winkelschleifer, aufweisend ein erfindungsgemäßes Abdeckelement oder aufweisend ein erfindungsgemäßes Klemmsystem, oder aufweisend ein erfindungsgemäßes System.

Weitere Vorteile, Merkmale und Anwendungsmöglichkeiten der vorliegenden Erfindung ergeben sich aus der nachfolgenden Beschreibung in Zusammenhang mit den Figuren:
Fig. 1 zeigt eine perspektivische Ansicht, schräg von vorne, eines erfindungsgemäßen Abdeckelements gemäß einem Ausführungsbeispiel.
Fig. 2 zeigt eine perspektivische Ansicht, schräg von hinten, des Abdeckelements der Fig. 1.
Fig. 3 zeigt eine perspektivische Ansicht, schräg von vorne, einer mit dem Abdeckelement der Fig. 1 abdeckbaren Federkraftklemmeinrichtung, die in einen Vergussbecher eingesetzt ist.
Fig. 4 zeigt eine perspektivische Ansicht, schräg von hinten, der in Fig.3 gezeigten Federkraftklemmeinrichtung, die in den Vergussbecher eingesetzt wird.
Fig. 5 zeigt in perspektivischer Explosionsansicht, von schräg vorne oben, ein System bestehend aus dem Abdeckelement der Fig. 1 sowie der Federkraftklemmeinrichtung und dem Vergussbecher der Fig. 3 oder 4.
Fig. 6 zeigt in perspektivischer Explosionsansicht, von schräg hinten unten, das System der Fig. 5 und ein in das Abdeckelement und in die Federkraftklemmeinrichtung einführbare Anschlusslitze.
Fig. 7 zeigt, in perspektivisch transparenter Seitendarstellung, das Abdeckelement der Fig. 1.
Fig. 8 zeigt in perspektivisch transparenter Seitendarstellung, die Federkraftklemmeinrichtung der Fig. 3.
Fig. 9 zeigt in perspektivisch transparenter Seitendarstellung, den Vergussbecher der Fig. 3.
Fig. 10 zeigt in perspektivisch transparenter Seitendarstellung, die in einem Klemmsystem zusammengesetzten Komponenten der Figuren 7, 8 und 9.
Fig. 11 zeigt, in perspektivischer Seitendarstellung, die in einem Klemmsystem zusammengesetzten Komponenten der Figur 6.
Fig. 12 zeigt eine perspektivische Ansicht, schräg von vorne, einer mit zwei Klemmsystemen der Fig. 11 versehenen, mit Elektronikbauteilen bestückten Leiterplatte eines handgeführten Elektrowerkzeugs, ohne die Anschlusslitzen.
Fig. 13 zeigt eine Querschnittsansicht des Abdeckelements der Fig. 1.
Fig. 14 zeigt ein Detail der Fig. 13.

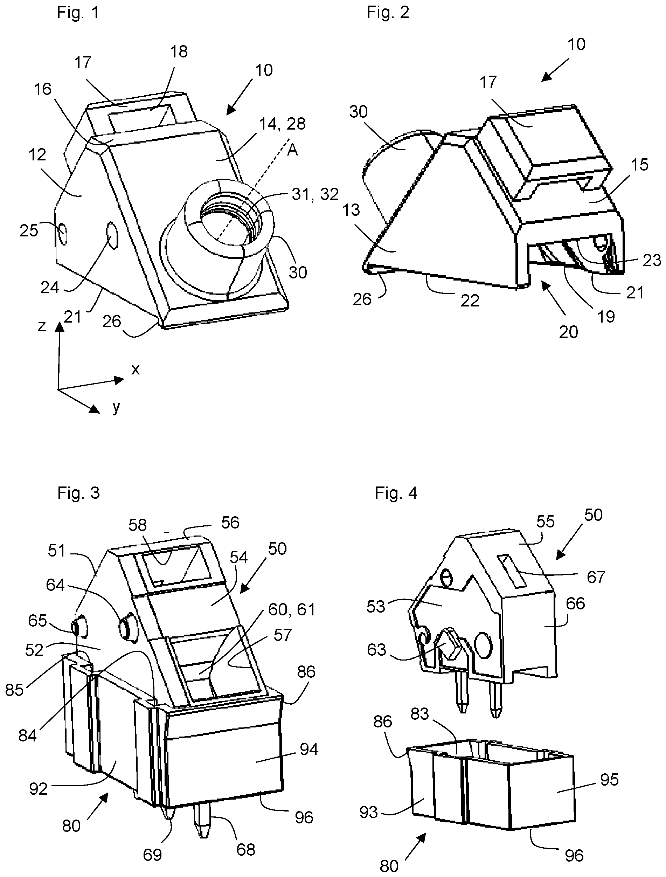

Fig. 1 zeigt ein Abdeckelement 10 zum Abdecken einer mit einer Leiterplatte verbindbaren Federkraftklemmeinrichtung 50. Diese dient der lösbaren Verbindung einer Netzleitung mit dem entsprechenden Netzspannungskontakt auf einer Leiterplatte, welche die Elektronikeinheit eines handgehaltenen Elektrowerkzeugs, insbesondere Winkelschleifers, aufweist.

Das Abdeckelement 10 liegt als ein hier im additiven Herstellungsverfahren integral gefertigtes Abdeckelement 10 vor. Dieses ist auf eine Federkraftklemmeinrichtung 50 aufsetzbar, um diese, mit eingesetzter Anschlusslitze 100, in staubhaltiger Umgebung abzukapseln. Das Abdeckelement 10 ist als Kappenelement ausgebildet, also als Einhausung, die auf das durch die Federkraftklemmeinrichtung gebildete Bauteil 50 aufsetzbar ist. Es weist hier zwei gegenüber liegende senkrechte Seitenwände 12 und 13 auf, sowie eine schräge Frontwand 14 und eine schräge Rückwand 15.

Die Frontwand 14 bildet einen Abdeckabschnitt 28 zum Abdecken einer Leitungsaufnahme der Federkraftklemmeinrichtung in Form eines geöffneten Bereiches, der vor dem Eindringen von Metallstaub geschützt werden soll.

Ein Öffnungskanal 30 erstreckt sich senkrecht von der Frontwand 14 weg. Im Bereich der Frontwand 14 weist der Öffnungskanal eine erste Öffnung 33 auf, die in den Innenraum der Öffnung 20 des Abdeckelements mündet. Der Öffnungskanal 30 dient der form- und kraftschlüssigen Aufnahme der Anschlusslitze 100. An seiner Innenseite weist der Öffnungskanal 30 einen ringförmigen Vorsprung 31 auf, der konzentrisch um die zentrale Achse A des Öffnungskanals 30 verläuft. Der Vorsprung bildet nach innen den engsten Durchmesser des Öffnungskanals 30. Wenn eine Anschlusslitze 100 in den Öffnungskanal 30 eingeführt ist, dient der Vorsprung 31 dazu, den nachgiebigen Mantel 101 der Anschlusslitze 100 umlaufend einzudrücken. Dadurch wird die Öffnung des Öffnungskanals 30, insbesondere gas- und/oder staubdicht, gegen die Umgebung abgedichtet. Der Vorsprung 31 bildet somit ein Abdichtungsmittel 32. Zudem fixiert er die Anschlusslitze 100 gegen unerwünschte Bewegungen, z.B. Vibrationen, die die elektrische Kontaktierung der elektrischen Kontakte der Federklemmeinrichtung durch den Leiter 102 der Anschlusslitze 100 beeinträchtigen könnten.

Die Rückwand 15 weist ein Laschenelement 17 auf, das aus einer zur Rückwand 15 parallelen Platte gebildet ist, welche über zwei Sockelteile integral mit der Rückwand verbunden ist und einen Einführungskanal 18 zwischen der Platte und der Rückwand ausbildet. Das Laschenelement 17 ist nutzbar, um das Abdeckelement zu demontieren, indem ein Werkzeug in den Einführungskanal 18 eingeführt wird und das Abdeckelement mittels des Werkzeugs gegriffen wird, die Verbindung zwischen Abdeckelement und Federklemmeinrichtung durch Krafteinwirkung gelöst wird und das Abdeckelement so entfernt wird.

Die planaren Seitenwände 12, 13, die planare Front- 14 und die planare Rückwand 15 treffen sich in einem oberen Kantenbereich 16 und schließen so einen Innenraum des Abdeckelements 10 nach oben (in positive z-Richtung) ab. Die Wahl, Anordnung und Form der Wände hängt je nach Umsetzung von der Beschaffenheit der Federkraftklemmeinrichtung 50 ab, die vom Abdeckelement 10 abgedeckt werden soll.

Der Innenraum ist nach unten (in negative z-Richtung) geöffnet. Diese untere Öffnung 20 dient der Aufnahme des Oberteils der Federkraftklemmeinrichtung 50, die von unten in das Abdeckelement 10 aufgenommen wird und formschlüssig mit diesem verbunden wird.

Wie in Figur 2 zu sehen ist, ist die Rückwand 15 nicht vollständig bis nach unten in die Ebene gezogen, in der die Unterkanten 21, 22 der Seitenwände liegen. Stattdessen endet die Unterkante 23 der Rückwand 15 oberhalb dieser Ebene. Dadurch wird das Einführen der Federkraftklemmeinrichtung 50 durch die Öffnung 20 in den Innenraum des Abdeckelements 10 erleichtert.

Das Aufsetzen des Abdeckelements 10 auf die Federkraftklemmeinrichtung wird durch eine Führungseinrichtung des Abdeckelements 10 vereinfacht. Die Führungseinrichtung beinhaltet die Führungsnut 19, die sich von der Unterkante 21 der Innenseite der Seitenwand 12 linear in Richtung schräg nach oben erstreckt. Die Richtung der Führungsnut verläuft parallel zur virtuellen Achse A, die die Längsachse des hohlzylinderförmigen Öffnungskanals 30 bildet.

Beim Montieren des Abdeckelements 10 an der Federkraftklemmeinrichtung 50 bis in die montierte Position (Montageposition) erstreckt sich gemäß einer bevorzugten Ausgestaltung des Klemmsystems 200 eine Anschlusslitze 100 bereits durch den Öffnungskanal 30 des Abdeckelements 10, wobei der Leiter 102 bereits in den metallischen Klemmbacken (nicht gezeigt) der Federkraftklemmeinrichtung eingeklemmt ist. Die Klemmbacken sind Bestandteile der im Inneren der Federkraftklemmeinrichtung angeordneten Klemmeinrichtung. Da beim Einführen des Leiters in die Klemmbacken das Abdeckelement 10 noch nicht montiert ist, kann ein Benutzer den Erfolg der Kontaktierung durch den geöffneten Bereich der Leitungsaufnahme visuell kontrollieren, welcher den Blick auf die Kontakte erlaubt.

Zum Aufsetzen des Abdeckelements 10 auf die Federkraftklemmeinrichtung wird dann das Abdeckelement 10 entlang der Anschlusslitze 100 bewegt, die in den geöffneten Bereich der Federkraftklemmeinrichtung 50 eingeführt ist und deren Leiter in den Klemmbacken mündet. Der geöffnete Bereich dient dazu, den Zugang des Leiters in die Klemmeinrichtung zu ermöglichen. Wenn das Abdeckelement 10 in der Montageposition mit der Federkraftklemmeinrichtung verbunden ist, ist der Öffnungskanal 30 des Abdeckelements 10 zum geöffneten Bereich 57 der Federkraftklemmeinrichtung 50 so ausgerichtet, dass die Anschlusslitze durch den geöffneten Bereich 57 führt. Die parallel zum Öffnungskanal 30 und der darin angeordneten Anschlusslitze 100 ausgerichtete Führungsnut 19 folgt dieser Richtung der Achse A, wodurch ein widerstandsfreies und gerichtetes Montieren des Abdeckelements 10 ermöglicht wird.

Gemäß einer anderen bevorzugten Verwendung des Klemmsystems 200 wird zunächst das Abdeckelements 10 an der Federkraftklemmeinrichtung bis in die montierte Position (Montageposition) montiert. Erst dann wird die Anschlusslitze 100 in den Öffnungskanal eingeführt, so dass er in die Leitungsaufnahme der Federkraftklemmeinrichtung eingeführt wird und der Leiter 102 zwischen die Klemmbacken 61 geschoben wird. Da beim Einführen des Leiters 102 in die Klemmbacken 61 das Abdeckelement 10 bereits montiert ist, kann ein erfahrener Benutzer den Erfolg der Kontaktierung wegen der Abdeckung durch das Abdeckelement 10 zwar nicht visuell kontrollieren, er kann aber das erfolgreiche Kontaktieren taktil erfassen.

Die Frontwand 14 des Abdeckelements 10 weist an ihrer Unterkante eine Verlängerung 26 auf, die einen nach hinten (in negative y-Richtung) weisenden, hakenartigen Vorsprung beinhaltet, der einen Verbindungsabschnitt 26 bildet. Dieser wirkt, in der Montageposition des Abdeckelements auf der Federkraftklemmeinrichtung, durch formschlüssige Anlage an einer komplementär verlaufenden Kante 86 des Becherelements 80 einer Verschiebung des Abdeckelements relativ zur Federkraftklemmeinrichtung nach hinten entgegen.

In Fig. 1 sind zudem die zylindrischen Öffnungen 24 und 25 in der Seitenwand 12 des Abdeckelements 10 zu erkennen. Diese Öffnungen 24, 25 bilden jeweils einen Verbindungsabschnitt zur Verbindung des Abdeckelements 10 mit stiftartigen Vorsprüngen 64, 65 eines jeweils komplementären Verbindungsabschnitt der Federkraftklemmeinrichtung 50.

In Montageposition des Abdeckelements 10 an der Federkraftklemmeinrichtung 50 ist, bei in den Öffnungskanal 30 eingesetzter Anschlusslitze 100, keine Öffnung zwischen dem Innenraum des Abdeckelements 10 und der Umgebung mehr vorhanden, durch die Staub in den Innenraum eintreten könnte. Die Unterkanten 21, 22 schließen mit der Außenkontur des Gehäuses der Federkraftklemmeinrichtung 50 und der Oberkante 86 des Becherelements 80 ab, welches auch als optionaler Bestandteil der Federkraftklemmeinrichtung 50 angesehen werden kann. Die Öffnungen 24 und 25 in der Seitenwand 12 sind durch die komplementären Verbindungsstifte 64, 65 der Federkraftklemmeinrichtung geschlossen und der Öffnungskanal 30 ist dicht durch die Anschlusslitze 100 verschlossen.

Fig. 3 zeigt die Federkraftklemmeinrichtung 50, die in den als Becherelement dienenden Vergussbecher 80 eingesetzt ist. Der Vergussbecher dient dem Schutz der darin angeordneten Bestandteile vor dem Kontakt mit Vergussmasse. Die Federkraftklemmeinrichtung 50 ist im Ausführungsbeispiel eine kommerziell erhältliche Federkraftklemme und das Becherelement 80 ist im Ausführungsbeispiel ein dazu passender, Vergussbecher. Das Abdeckelement 10 wurde in Form und Eigenschaften speziell an diese Bauteile angepasst und eignet sich in diesem Fall insbesondere zum Nachrüsten der Bauteile mit einem erfindungsgemäßen Abdeckelement 10.

Die Federkraftklemmeinrichtung 50 weist ein Gehäuse 51 auf, dessen Form so ist, dass es an die Innenkontur des Abdeckelementes 10 angepasst ist. Entsprechend weist es parallel gegenüberliegende, vertikal nach unten verlaufende Seitenwände 52 und 53 auf, eine schräge Frontwand 54 und eine schräge Rückwand 55, wobei diese Wände in der Oberkante 56 zusammenlaufen, die in Montageposition unmittelbar der Innenseite der Oberkante 16 des Abdeckelements 10 gegenüberliegt. Unterhalb der schrägen Rückwand 55 des Gehäuses 51 schließt sich die vertikal nach unten verlaufende Rückwand 66 an. Durch den vertikalen Verlauf sind diese Rückwand 66 und die Seitenwände 52, 53 in das Becherelement 80 von oben einschiebbar. Das Becherelement weist die vertikalen Seitenwände 92 und 93, sowie die vertikale Frontwand 94 und die vertikale Rückwand 95 auf. Diese Wände verlaufen bis zur Bodenplatte 96, mit der sie integral verbunden sind.

Die schräge Frontwand 54 weist die Leiteraufnahme 57 auf, die ein geöffneter Bereich 57 der Frontwand ist. Dieser ist in Montageposition des Abdeckelements 10 auf der Federkraftklemmeinrichtung 50 zentriert auf der Achse A, welche die Längsachse des Öffnungskanals 30 ist.

Das zweiteilig aufgebaute Gehäuse 51 weist auf der schrägen Frontwand 54 insbesondere eine Eingriffsöffnung 58 auf, durch die ein Benutzer mit einem Werkzeug eingreifen kann, um die Feder der Klemmkontakte aufzuspannen, so dass der Leiter 102 entnehmbar ist. Auch die schräge Rückwand 55 weist eine Rastöffnung 67 auf. Diese Öffnungen 57, 67, 58 werden durch das Abdeckelements 10 abgedeckt, wodurch verhindert wird, dass metallischer Staub in das Gehäuse 51 eindringen kann.

Die Federkraftklemmeinrichtung 50 muss nicht grundsätzlich ein Gehäuse aufweisen, denn das Abdeckelement 10 kann deren Gehäuse bilden. Die Klemmeinrichtung 60 mit den Klemmbacken 61 und den Kontaktpins 68 und 69 könnte auch auf einem Basisteil angeordnet sein, das vom Abdeckelement 10 abgedeckt sein könnte. Anstelle einer Eingriffsöffnung für einen Werkzeugeingriff zum Lösen der Klemmeinrichtung könnte das Abdeckelement 10 dann zum Beispiel ein beweglich und formschlüssig in einer Eingriffsöffnung des Abdeckelements 10 angeordnetes Betätigungselement aufweisen, mittels dessen Manipulation ein Benutzer die Klemme lösen könnte.

Zur Führung des Einschiebens der Federkraftklemmeinrichtung 50 in das Becherelement 80 sind Führungseinrichtungen vorgesehen, welche die unteren Stiftvorsprünge 74 und 75 auf der Seitenwand 52 des Gehäuses 51 als Führungselemente beinhaltet. Diese Führungselemente werden beim Einführen von den vertikalen Nuten 84 und 85 in der Seitenwand 92 des Becherelements 80 geführt.

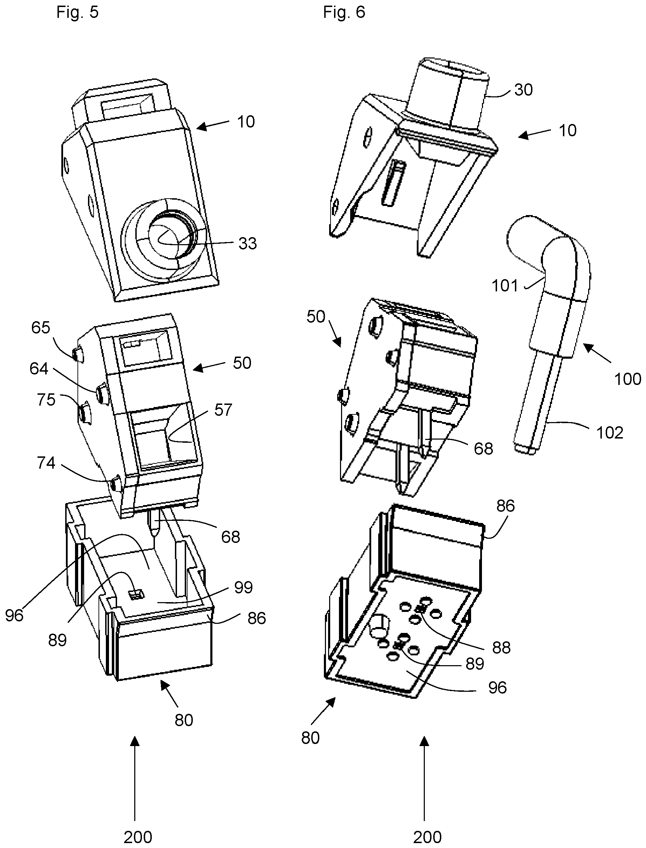

Wie in Figur 4 zu sehen ist, befindet sich auf der Seitenwand 53 der Vorsprung 63, der ebenfalls als Führungselement dient, welcher in der vertikal verlaufenden Nut 83 auf der Seitenwand 93 des Becherelements 80 geführt wird. Durch die Führungselemente wird sichergestellt, dass bei Montage der Federkraftklemmeinrichtung 50 im Becherelement 80 die Kontaktstifte 68 und 69 der Federkraftklemmeinrichtung 50 exakt in die zugeordneten Öffnungen 88 und 89 der Bodenplatte 96 (Figur 6) des Becherelements geführt werden. Dadurch können die Kontaktstifte in der Montageposition der Federkraftklemmeinrichtung 50 durch das Becherelement 80 ragen, um mit entsprechenden Kontaktstellen auf der Leiterplatte verbindbar zu sein.

Im Inneren der Federkraftklemmeinrichtung 50 ist die Klemmeinrichtung 60 so angeordnet, dass deren Klemmbacken 61 in Richtung nach Innen entlang der Achse A auf die Leiteraufnahme 57 folgen. Die Klemmbacken 61 sind metallisch und elektrisch mit den metallischen Kontaktpins 68 und 69 verbunden.

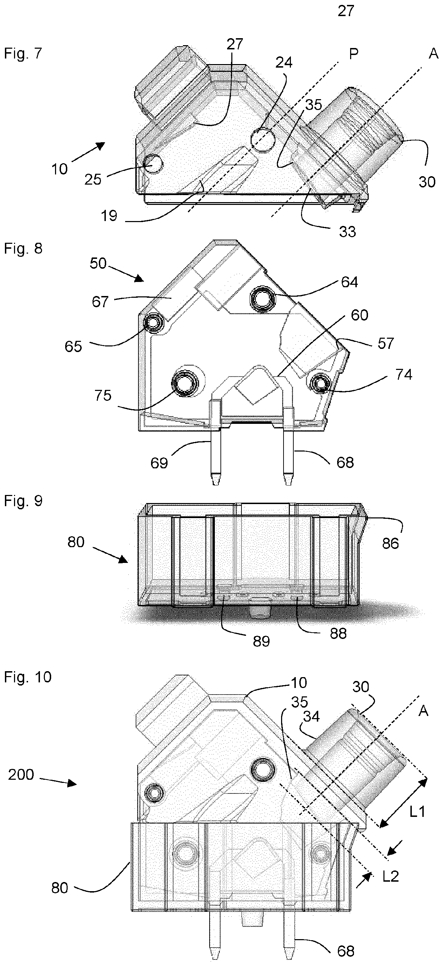

Auch in Fig. 4 zu sehen ist die schlitzförmige Öffnung 67, die als Rastöffnung zum Eingriff des Rastnockens 27 dient, der zum Beispiel in Fig. 7 gezeigt ist.

Fig. 5 zeigt eine Explosionsdarstellung eines Klemmsystems 200, welches das Abdeckelement 10, die Federkraftklemmeinrichtung 50 und das Becherelement 80 beinhaltet. Der Blick von oben in das Becherelement 80 zeigt die Oberseite der Bodenplatte 96 des Becherelements, die von einer Barriereschicht 99 bedeckt ist. Die Barriereschicht 99 besteht aus elektrisch nichtleitendem elastischen Material und ist Bestandteil der Bodenplatte 96. Die Barriereschicht verhindert das Eindringen von Staub in Richtung der Kontaktpins 68, 69 und/oder das Eindringen von Vergussmasse durch die Bodenöffnungen 88, 89 in das Becherelement 80 bzw. in die Federkraftklemmeinrichtung 50. Alle Komponenten 10, 50 und 80 des Klemmsystems bestehen aus elektrisch nichtleitendem Material, z.B. Thermoplast.

Die Barriereschicht gegenüber Eindringen von Staub in Richtung der Kontaktpins 68 und 69 kann auch stoffschlüssig ausgeführt sein, indem an der inneren Wandung der Bodenplatte 96 des Becherelements 80 speziell hierfür vorgesehene erhabene Strukturen durch Ultraschallschweißen die Bodenöffnungen 88 und 89 vollständig umschließen und mit der Bodenseite der Federkraftklemmeinrichtung 50 verbinden.

Zusammen mit der Federkraftklemme 50 und der Barriereschicht 99 bildet der Vergussbecher 80 eine THT (Through Hole Technology) assemblierbare Elektronikbaugruppe, die direkt in eine Leiterplatte eingesetzt und verlötet werden kann.

Auch Fig. 6 zeigt das Klemmsystem 200 der Fig. 5, von unten, zuzüglich der in den Öffnungskanal 30 einzusetzenden Anschlusslitze 100.

Fig. 7 zeigt eine transparente Seitenansicht des Abdeckelements 10. Hier ist insbesondere erkennbar, dass die Führungsnut 19, in welcher der Verbindungsstift 64 geführt wird, letztlich in der Öffnung 24 mündet. Beim Aufsetzen des Abdeckelements 10 auf die Federkraftklemmeinrichtung 50 gleitet die Führungsnut 19 des Abdeckelements 10 entlang dem Verbindungsstift 64, bis in der Montageposition der Verbindungsstift 64 in die Öffnung 24 eintritt und in diese formschlüssig eingreift. Dabei verläuft der Pfad P der Führungsnut 19 parallel der Achse A des Öffnungskanals, wie hier gut zu sehen ist.

Die Innenseite der Frontwand 14 des Abdeckelements 10 weist einen Innenabschnitt 35 des Öffnungskanals 30 auf, der sich von der Innenseite der Frontwand 14 entlang der Achse A nach innen erstreckt. In der Montageposition greift der Innenabschnitt 35 formschlüssig in die Leiteraufnahme 57 der Federkraftklemmeinrichtung 50 ein und bildet deshalb einen Verbindungsabschnitt 35, der sich mit dem als Leiteraufnahme dienenden Verbindungsabschnitt 57 verbindet. Der Innenabschnitt 35 weist die erste Öffnung 33 des Öffnungskanals auf, die in der Montageposition innerhalb der Leiteraufnahme 57 angeordnet ist.

Der Rastnocken 27 ist an der Innenseite der Rückwand 15 des Abdeckelements ausgebildet. In der Montageposition, in der das Abdeckelement 10 auf der Federkraftklemmeinrichtung 50 montiert und mit dieser verbunden ist, ist der Rastnocken 27 in die Rastöffnung 67 der Federkraftklemmeinrichtung 50 eingerastet.

Fig. 8 zeigt die transparente Seitenansicht der Federkraftklemmeinrichtung 50, in deren Inneren die Klemmeinrichtung 60 mit Kontaktpins 68, 69 auszugsweise erkennbar ist.

Fig. 9 zeigt die transparente Seitenansicht des Becherelements 80, bei dem insbesondere die Öffnungen 88, 89 in der Bodenplatte erkennbar sind.

Fig. 10 zeigt die transparente Seitenansicht des Klemmsystems 200, das bis auf die Öffnung des Öffnungskanals 30 staubdicht verkapselt ist. Gezeigt ist, dass die maximale Länge L1 des von der Außenseite der Frontwand 14 nach außen weisenden Außenabschnitts 34 des Öffnungskanals 30 mehrfach größer ist als die Länge L2 des Innenabschnitts 35 des Öffnungskanals 30. Der Außenabschnitt 34 könnte aber grundsätzlich auch kürzer sein, insbesondere könnte auch L2 = L1 sein oder L2 > L1, vorzugsweise auch L1=0 und/oder L2=0. Es könnte sich insbesondere der Öffnungskanal nur durch die Dicke einer Wand, insbesondere hier der Frontwand 14, des Abdeckelements erstrecken.

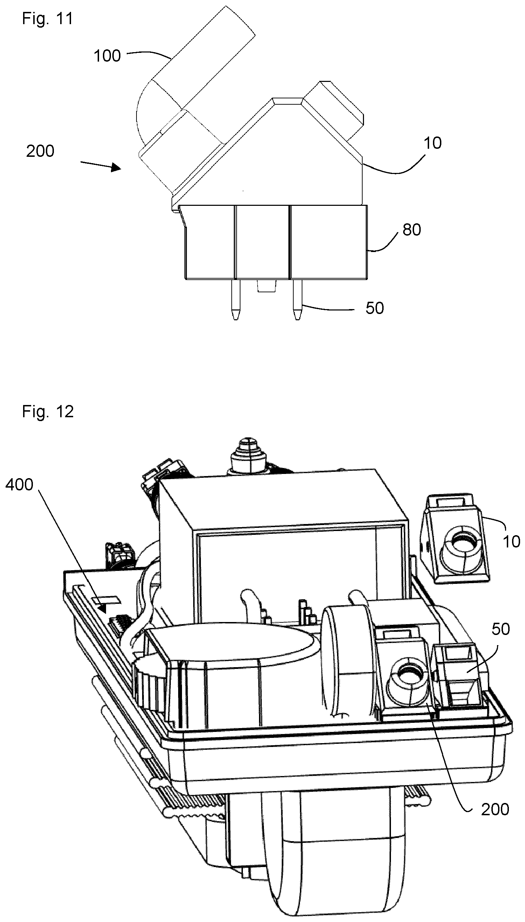

Fig. 11 zeigt das Klemmsystem 200 in der Anschlusskonfiguration, in der die Anschlusslitze 100 in den Öffnungskanal eingesetzt ist und der Leiter in der Klemmeinrichtung 60 eingeklemmt und elektrisch kontaktiert ist. Nach Einsetzen der Anschlusslitze 100 ist das Klemmsystem 200 staubdicht verkapselt.

Fig. 12 zeigt eine perspektivische Ansicht einer mit Elektronikkomponenten bestückten Leiterplatte 400 eines handgehaltenen Elektrowerkzeugs, insbesondere Winkelschleifers, auf der zwei Klemmsysteme 200 angebracht sind und dem Anschluss der Netzkabel dienen.

Die bestückte Leiterplatte wurde vergossen. Der Elektronikverguss schützt die elektronischen Komponenten vor Verschmutzung. Zur Reduzierung des Risikos eines Eintritts von Vergussmasse gibt es Vergussbecher 80. Diese sollen den Kriechprozess des Vergussmaterials verhindern und sicherstellen, dass die Federkraftklemme 50 nicht durch einen Elektronikverguss vollläuft und dadurch deren Funktion nicht mehr gewährleistet ist. Allerdings hat sich herausgestellt, dass ein Vergussbecher 80 alleine dieses Problem nicht behebt. Deshalb ist erfindungsgemäß innerhalb des Vergussbechers an dessen Boden eine Barriereschicht 99 vorgesehen, welches den Eintritt der Vergussmasse in den Becher 80 verhindert. Zusätzlich stellt die Barriereschicht sicher, dass sie die Kontaktpins 68, 69 umschließt und somit eventuell eintretende metallische Fremdkörper keinen Kurzschluss verursachen können. Dieses Mittel kann eine stoffschlüssige Paste sein, die eine Barriereschicht darstellt. Die Barriereschicht kann alternativ auch aus formschlüssigen Elementen gebildet sein, wobei beispielsweise Erhebungen in Form von Vorsprüngen am Boden des Vergussbechers mit Ausnehmungen in Form von Nuten an der Federkraftklemme zusammenwirken, um eine stoffdichte Verbindung zu bilden.

Der Vergussbecher 80 bildet hier eine Schnittstelle zum erfindungsgemäßen Abdeckelement 10, damit diese den oberen Teil der Federkraftklemme hinreichend abdichten kann. Die Barriereschicht 99 stellt sicher, dass der zur Bodenplatte hin gerichtete Teil der Federkraftklemme 50 und hier insbesondere die Kontakte 68, 69 der Federkraftklemme, die als Schnittstelle zur Leiterplatte hin fungieren, passiviert sind. Die Abdeckkappe 10 nimmt kraftschlüssig die Anschlusslitze 100 der Netzleitung auf und wird, nachdem die Anschlusslitze mit der Federkraftklemme verbunden wurde, formschlüssig auf die Federkraftklemme aufgesetzt, wodurch der oben aus dem Elektronikverguss reichende Teil der Federkraftklemme 50 abgeschirmt ist und mit dem Vergussbecher 80 abschließt. An der Abdeckkappe 10 können sich weitere Elemente befinden, die die Demontage der Abdeckkappe 10 erleichtern und oder zur Verlegung der Anschlusslitzen 100 der Netzanschlussleitung im Elektrowerkzeug dienen.

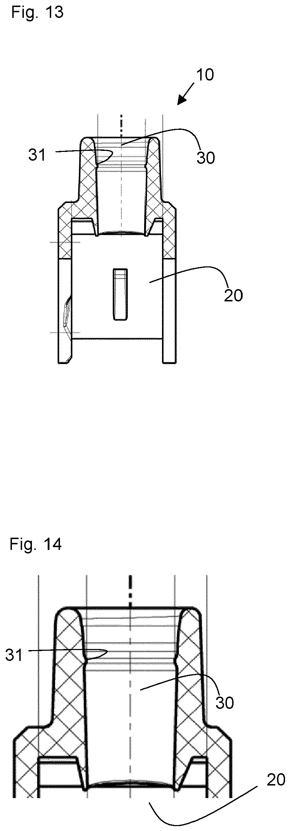

Die Figur 13 zeigt einen Querschnitt des Abdeckelements 10 entlang der Achse A des Öffnungskanals 30 und senkrecht zu den Seitenwänden 12 und 13.

Es ist der Öffnungskanal 30 zu sehen, der an seiner Innenseite den ringförmigen Vorsprung 31 aufweist, der hier die engste Stelle im Öffnungskanal darstellt und somit als ein wirksames Abdichtmittel dient. Zusätzlich ist zu erkennen, dass der Öffnungskanal 30 in Richtung des Innenraums 20 des Abdeckelements sich verjüngt. Mit anderen Worten, an der Mündung 33 des Öffnungskanals 30 in den Innenraum 20 ist dessen Durchmesser geringer als am Öffnungskanaleingang, in den von außerhalb eine Anschlusslitze in das Abdeckelement zur Verbindung mit der Federkraftklemmeinrichtung eingeführt wird.

Fig. 14 zeigt ein vergrößertes Detail der Figur 13. Die Verjüngung in Richtung Innenraum 20 und der Vorsprung 31 sind deutlich zu erkennen.

**Bezugszeichenliste**

| | |
|---|---|
| 10 | Abdeckelement |
| | |
| 12, 13 | Seitenwand |
| 14 | Frontwand |
| 15 | Rückwand |
| 16 | Kantenbereich |
| 17 | Laschenelement |
| 18 | Einführungskanal |
| 19 | Führungsnut |
| 20 | Öffnung |
| 21,22 | Unterkante |
| 23 | Unterkante von 15 |
| 24, 25 | Öffnung |
| 26 | Verlängerung, Verbindungsabschnitt |
| 28 | Abdeckabschnitt |
| 27 | Rastnocken |
| 30 | Öffnungskanal |
| 31 | Vorsprung |
| 32 | Abdichtungsmittel |
| 33 | erste Öffnung, Mündung |
| 34 | Außenabschnitt |
| 35 | Innenabschnitt |
| 50 | Federkraftklemmeinrichtung |
| 51 | Gehäuse |
| 52, 53 | Seitenwand |
| 54 | Frontwand |
| 55 | Rückwand |
| 56 | Oberkante |
| 57 | Bereich, Leiteraufnahme |
| 58 | Eintrittsöffnung |
| 60 | Klemmeinrichtung |
| 61 | Klemmbacken |
| 63 | Vorsprung |
| 64,65 | Vorsprung, Verbindungsstift |
| 66 | Rückwand |
| 67 | Rastöffnung |
| 68,69 | Kontaktpins |
| 80 | Becherelement |
| 83 | Nut |
| 84, 85 | Nut |
| 86 | Kante |
| 88, 89 | Öffnung |
| 92,93 | Seitenwand |
| 94 | Frontwand |
| 95 | Rückwand |
| 96 | Bodenplatte |
| 99 | Barriereschicht |
| 100 | Anschlußlitze |
| 101 | Isolationsmaterial |
| 102 | Leiter |
| 200 | Klemmsystem |
| 400 | Leiterplatte |
| | |
| A | Achse |
| L1 | Länge des Außenabschnitts 34 |
| L2 | Länge des Innenabschnitts 35 |

## Patentansprüche

1. Abdeckelement (10) zum Abdecken einer mit einer Leiterplatte (400) verbindbaren Federkraftklemmeinrichtung (50), aufweisend
einen Verbindungsabschnitt (24; 25; 27; 35) zur Verbindung des Abdeckelements (10) mit einem Verbindungsabschnitt (64; 65; 67) der Federkraftklemmeinrichtung (50) und
einen Abdeckabschnitt (28) zum Abdecken einer Leiteraufnahme (57) der Federkraftklemmeinrichtung (50),
wobei der Abdeckabschnitt (28) einen Öffnungskanal (30) zur formschlüssigen und/oder kraftschlüssigen Aufnahme einer Anschlusslitze (100) aufweist, durch den ein Leiter (102) der Anschlusslitze (100) führbar und in die Leitungsaufnahme (57) der Federkraftklemmeinrichtung (50) einführbar ist.

2. Abdeckelement gemäß Anspruch 1, wobei der Öffnungskanal (30) hohlzylinderförmig und zur form- und/oder kraftschlüssigen Aufnahme einer zylinderförmigen Anschlusslitze (100) ausgebildet ist.

3. Abdeckelement gemäß Anspruch 1 oder 2, wobei der Öffnungskanal (30) mindestens ein Abdichtungsmittel (32) aufweist, insbesondere um das Eindringen von Partikeln durch den Öffnungskanal (30) zu verhindern.

4. Abdeckelement gemäß Anspruch 3, wobei das Abdichtungsmittel (32) einen ringförmigen Vorsprung (31) an der Innenseite des Öffnungskanals (30) beinhaltet.

5. Abdeckelement gemäß Anspruch 4, wobei dieser Vorsprung (31) dazu ausgebildet ist, zwischen dem Öffnungskanal (30) und der Anschlusslitze (100) eine kraftschlüssige Verbindung zu erzeugen, indem der Vorsprung (31) in ein nachgiebiges Material eines Isolationsmantels (101) der Anschlusslitze (100) pressbar ist.

6. Abdeckelement gemäß einem der vorangehenden Ansprüche, wobei sich der Öffnungskanal (30) vom Abdeckabschnitt (28) entlang einer Längsachse (A) weg erstreckt eine erste Öffnung (33) aufweist, in welche eine Anschlusslitze in den Öffnungskanal (30) einführbar ist, und wobei der Öffnungskanal (30) einen Kanalabschnitt aufweist, der in Richtung der ersten Öffnung (33) einen abnehmenden Öffnungsquerschnitt hat und der insbesondere in der ersten Öffnung (33) mündet.

7. Abdeckelement gemäß einem der vorangehenden Ansprüche, wobei der Öffnungskanal (30) einen Öffnungsquerschnitt, gemessen senkrecht zu einer Längsachse (A) des Öffnungskanals, mit einem Durchmesser zwischen 1 mm und 4 mm aufweist.

8. Abdeckelement gemäß einem der vorangehenden Ansprüche, das ein integral gefertigtes Bauteil ist, insbesondere ein mittels additivem Herstellungsverfahren oder Spritzguss gefertigtes Bauteil.

9. Abdeckelement gemäß einem der vorangehenden Ansprüche, das eine Führungsnut (19) aufweist, mittels der der Abdeckkörper entlang einer definierten Richtung (P), insbesondere parallel zur Längsachse (A) des Öffnungskanals, auf eine Federkraftklemmeinrichtung (50) aufschiebbar ist.

10. Klemmsystem (200), aufweisend das Abdeckelement (10) gemäß einem der Ansprüche 1 bis 9 und eine Federkraftklemmeinrichtung (50) mit einer Leiteraufnahme (57), die vom Abdeckabschnitt (28) des Abdeckelements (10) abgedeckt ist.

11. Klemmsystem (200) gemäß Anspruch 10, wobei das Abdeckelement (10) die Federkraftklemmeinrichtung (50) in einer Montageposition vollständig verkapselt und den Öffnungskanal (30) als alleinige Öffnung aufweist.

12. Klemmsystem (200) gemäß Anspruch 10 oder 11, aufweisend eine ein- oder mehradrige Anschlusslitze (100), die einen Isoliermantel ( 101) aufweist, welcher form- und/oder kraftschlüssig im Öffnungskanal (30) des Abdeckelements (10) angeordnet ist.

13. Leiterplatte (400), die insbesondere mit mindestens einem elektronischem Bauteil bestückt ist, und die ein Abdeckelement gemäß einem der Ansprüche 1 bis 9 oder ein Klemmsystem gemäß einem der Ansprüche 10 bis 12 aufweist.

14. Handgehaltenes Elektrowerkzeug, insbesondere Winkelschleifer, aufweisend ein Abdeckelement (10) gemäß einem der Ansprüche 1 bis 9, oder aufweisend ein Klemmsystem (200) gemäß einem der Ansprüche 10 bis 12 oder aufweisend eine Leiterplatte gemäß Anspruch 13.

15. Verfahren zur Herstellung des Abdeckelements (10) gemäß Anspruch 1, aufweisend die Schritte:
* Bereitstellen eines Materials, insbesondere eines nicht elektrisch leitfähigen Kunststoffs;
* Fertigen des Abdeckelements (10) als integrales Bauteil, insbesondere mittels eines additiven Herstellungsverfahrens oder mittels eines Spritzgussverfahrens.
